# EUROPEAN PATENT SPECIFICATION

(11) **EP 3 144 981 B1**
(45) Date of publication and mention of the grant of the patent: **07.06.2023**
(21) Application number: 16189015.7
(22) Date of filing: 15.09.2016
(51) Int. Cl.: H01L 31/05

(54) **SOLAR CELL MODULE**
SOLARZELLENMODUL
MODULE DE CELLULE SOLAIRE

(30) Priority: 15.09.2015 KR 20150130294
(43) Date of publication of application: 22.03.2017
(73) Proprietor: Shangrao Jinko solar Technology Development Co., LTD, JIANGXI PROVINCE (CN)
(72) Inventor: WOO, Taeki, 08592 Seoul (KR); YANG, Hyeyoung, 08592 Seoul (KR)
(74) Representative: DREISS Patentanwälte PartG mbB

(56) References cited:
- EP-A1- 2 966 693
- EP-A2- 2 911 206
- JP-A- 2005 191 125
- US-A- 5 158 618
- US-A1- 2007 199 588
- US-A1- 2012 247 530

## Description

### CROSS-REFERENCE TO RELATED APPLICATION

This application claims priority to and the benefit of Korean Patent Application No. 10-2015-0130294 filed in the Korean Intellectual Property Office on September 15, 2015.

### BACKGROUND OF THE INVENTION

### Field of the Invention

The embodiment of the invention and examples forming background art of the invention relate to a solar cell module.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes by the incident light. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

A plurality of solar cells having the above-described configuration may be connected to one another through interconnectors to form a module.

A solar cell according to a related art includes a plurality of finger electrodes each having a relatively small width and a bus bar electrode having a width greater than the width of the finger electrode and connecting the plurality of finger electrodes. A clip type interconnector serving as an intercell connector is directly connected to bus bar electrodes of adjacent solar cells, and a string of the solar cells is formed.

However, when the solar cell includes the bus bar electrode having the relatively large width, the bus bar electrode is relatively weak to an increase in efficiency of the solar cell because the bus bar electrode is not generally used to collect carriers.

Hence, a trend in forming electrodes of the solar cell using only the finger electrodes by omitting the bus bar electrode has recently increased.

However, when the solar cell includes only the finger electrodes as described above, the clip type interconnector directly connected to the electrodes of the solar cell cannot be used. Thus, a structure, in which a plurality of lines, that are relatively narrow and long, are entirely connected to the electrodes of the solar cell, has been increasingly used.

EP 2 966 693 A1 (this document falls under Art. 54(3) EPC) describes a solar cell module including a plurality of solar cells with first electrodes on a front surface of a semiconductor substrate and second electrodes on a back surface of the semiconductor substrate. Respective first and second electrodes of adjacent solar cells in the solar cell module are connected to each other by wiring members. The wiring members are configured to stretch in a longitudinal direction and for this purpose may have a twisted shape like a coil or a wrinkle shape having peaks and valleys.

US 2012/0247530 A1 describes electric couplers to connect solar cells in a solar panel. The electric couplers may act as springs or strain relieving devices along the length of the couplers between cells of the solar panel.

JP 2005 191125 A describes belt-like connection tabs for connecting adjacent solar battery elements. Parts of the connection tabs that do not overlap the solar battery elements have bending portions formed therein, each of which is bent 3-20 times.

US Patent No. 5,158,618 proposes to utilize current collecting contacts of various planar and three-dimensional forms on the substrate of a solar cell. Electrically connected intermittent sections of the current collecting contacts are in and out of contact with a surface of the substrate, respectively. The current collecting contacts may be used for interconnecting the solar cell with other solar cells to form a battery.

US 2007/0199588 A1 teaches a solar cell system with a plurality of solar cell modules, wherein each solar cell module comprises front side electrodes with a front side terminator and back side electrodes with a back side terminator. Adjacent solar cell modules may be connected by soldering together a back side terminator of a solar cell module with a front side terminator of an adjacent solar cell module thereby forming a side connector. The side connector may be folded under the modules to enable the modules to be abutted closely together.

EP 2 911 206 A2 discloses a solar cell module with a plurality of solar s, according to the preamble of claim 1. A solar cell comprises a semiconductor substrate and a plurality of first electrodes and a plurality of second electrodes on a back surface of the semiconductor substrate. A first conductive line is connected to the first electrodes and a second conductive line is connected to the second electrodes of a solar cell. A first conductive line of a solar cell is connected with a second conductive line of an adjacent solar cell by means of an interconnector.

However, in the structure, in which the narrow and long lines are connected to the solar cell, the lines bend due to a thermal expansion of the lines in a process for connecting the lines to the solar cell or connecting the lines to the interconnector between the solar cells. Hence, a shape of the string is deformed.

### SUMMARY OF THE INVENTION

In one aspect, there is provided a solar cell module in accordance with claim 1. Preferred embodiments are defined in the dependent claims. A solar cell module in accordance with certain embodiments comprises: first and second solar cells each including a semiconductor substrate and first electrodes and second electrodes on the semiconductor substrate, the first and second electrodes having different polarities and extending in a first direction, the first and second solar cells being arranged adjacent to each other in a second direction crossing the first direction; and a plurality of conductive lines extending in the second direction, disposed on the semiconductor substrate of each of the first and second solar cells, and connected to the first electrodes or the second electrodes of each of the first and second solar cells to connect in series the first and second solar cells in the second direction, each conductive line including an uneven portion located in a remaining portion except a portion of the conductive line that is connected to the first electrode or the second electrode. An unevenness of the uneven portion may be in a thickness direction of the semiconductor substrate.

A thickness of the uneven portion of the each conductive line may be substantially equal to a thickness of a portion of the each conductive line not including the uneven portion within a margin of error of 10 %.

A thickness of the uneven portion may be uniform within a margin of error of 10 % over the entire uneven portion.

A height of the uneven portion may be greater than a thickness of the uneven portion.

A cross section of the uneven portion has a zigzag shape.

The uneven portion is positioned between the semiconductor substrates of the first and second solar cells.

The conductive line has flexibility in a second direction by the uneven portion

The uneven portion has a peak and a valley, each of which is extended in the first direction. A height of the uneven portion measured from the valley to the peak may be 0.03 mm to 1 mm.

The each conductive line may be formed as a conductor and may be connected to the first and second solar cells. The each conductive line formed as the conductor may be connected to the first electrode of the first solar cell through a conductive adhesive and may be insulated from the second electrode of the first solar cell through an insulating layer. The each conductive line formed as the conductor may be connected to the second electrode of the second solar cell through the conductive adhesive and may be insulated from the first electrode of the second solar cell through the insulating layer.

Each conductive line formed as the conductor may include the uneven portion between the semiconductor substrate of the first solar cell and the semiconductor substrate of the second solar cell.

The plurality of conductive lines includes a first conductive line connected to the first electrodes of each of the first and second solar cells through a conductive adhesive and insulated from the second electrodes of each of the first and second solar cells through an insulating layer, and a second conductive line spaced apart from the first conductive line, connected to the second electrodes of each of the first and second solar cells through the conductive adhesive, and insulated from the first electrodes of each of the first and second solar cells through the insulating layer.

The solar cell module further includes an interconnector extending between the first and second solar cells in the first direction. The first conductive line connected to the first solar cell and the second conductive line connected to the second solar cell are commonly connected to the interconnector.

The first conductive line includes the uneven portion in an area exposed between the semiconductor substrate of the first solar cell and the interconnector when viewed from a front of the solar cell module. Further, the second conductive line includes the uneven portion in an area exposed between the semiconductor substrate of the second solar cell and the interconnector when viewed from the front of the solar cell module.

The first electrodes and the second electrodes of each of the first and second solar cells are disposed to extend in the second direction on a back surface of the semiconductor substrate. The semiconductor substrate of each of the first and second solar cells may be doped with impurities of a first conductive type.

The first electrodes of each of the first and second solar cells may be connected to an emitter region positioned at the back surface of the semiconductor substrate and doped with impurities of a second conductive type opposite the first conductive type.

The second electrodes of each of the first and second solar cells may be connected to a back surface field region positioned at the back surface of the semiconductor substrate and more heavily doped than the semiconductor substrate with impurities of the first conductive type.

In each of the first and second solar cells of an exemplary solar cell module, the first electrodes may be disposed on a front surface of the semiconductor substrate, and the second electrodes may be disposed on a back surface of the semiconductor substrate. The plurality of conductive lines may be connected to the first electrodes on a front surface of the first solar cell and may be connected to the second electrodes on a back surface of the second solar cell to connect the first and second solar cells in series.

Each conductive line may include the uneven portion between the first and second solar cells.

The semiconductor substrate of each of the first and second solar cells may be doped with impurities of a first conductive type. The first electrodes of each of the first and second solar cells may be connected to an emitter region, that is positioned at the front surface of the semiconductor substrate and is doped with impurities of a second conductive type opposite the first conductive type. The second electrodes of each of the first and second solar cells may be connected to a back surface field region, that is positioned at the back surface of the semiconductor substrate and is more heavily doped than the semiconductor substrate with impurities of the first conductive type.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 to 5 illustrate a solar cell module according to the embodiment of the invention;
FIGS. 6 and 7 illustrate a solar cell module according to an example forming background art of the invention, not covered by the claims;
FIGS. 8 to 11 illustrate a solar cell module according to a further example forming background art of the invention, not covered by the claims; and
FIGS. 12 and 13 illustrate a solar cell module according to a still further example forming background art of the invention, not covered by the claims.

### DETAILED DESCRIPTION OF THE EMBODIMENTS

Reference will now be made in detail to the embodiment of the invention, examples of which are illustrated in the accompanying drawings, and examples. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the another element and may not be on a portion of an edge of the another element.

In the following description, "front surface" may be one surface of a semiconductor substrate, on which light is directly incident, and "back surface" may be a surface opposite the one surface of the semiconductor substrate, on which light is not directly incident or reflective light may be incident.

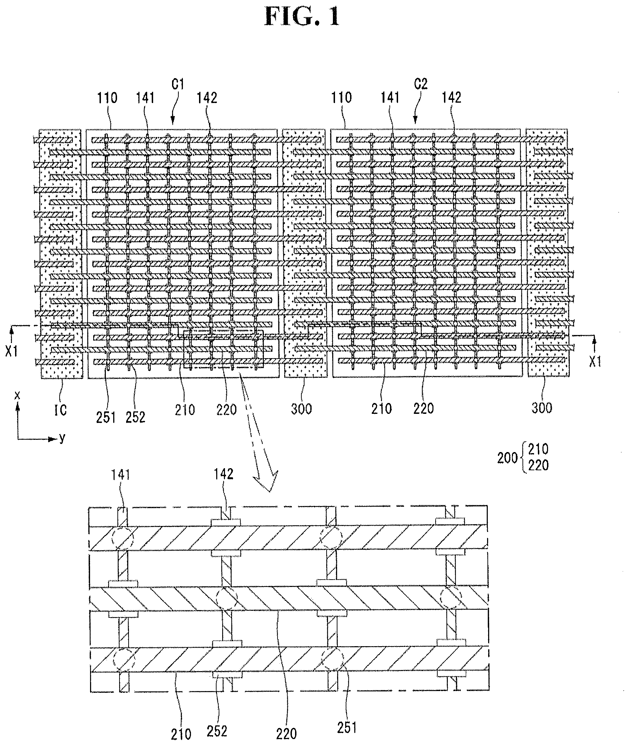

FIGS. 1 to 5 illustrate a solar cell module according to the embodiment of the invention.

More specifically, FIG. 1 illustrates an example of a shape of a solar cell module according to the embodiment of the invention when viewed from a back surface of the solar cell module.

As shown in FIG. 1, a solar cell module according to the embodiment of the invention may include a plurality of solar cells C1 and C2, a plurality of conductive lines 200, and an interconnector 300.

The embodiment of the invention is described using the solar cell module including the interconnector 300 as shown in FIG. 1.

Each of the plurality of solar cells C1 and C2 at least includes a semiconductor substrate 110 and a plurality of first and second electrodes 141 and 142 that are spaced apart from each other on a back surface of the semiconductor substrate 110 and extend in a first direction x.

The plurality of conductive lines 200 electrically connect in series a plurality of first electrodes 141 included in one solar cell of two adjacent solar cells among a plurality of solar cells to a plurality of second electrodes 142 included in the other solar cell through an interconnector 300.

To this end, the plurality of conductive lines 200 extend in a second direction y crossing a longitudinal direction (i.e., the first direction x) of the first and second electrodes 141 and 142 and are connected to each of the plurality of solar cells.

The plurality of conductive lines 200 include a plurality of first conductive lines 210 and a plurality of second conductive lines 220.

The first conductive line 210 is connected to the first electrode 141 included in each solar cell using a conductive adhesive 251 and insulated from the second electrode 142 of each solar cell through an insulating layer 252 formed of an insulating material.

Further, the second conductive line 220 is connected to the second electrode 142 included in each solar cell using the conductive adhesive 251 and insulated from the first electrode 141 of each solar cell through the insulating layer 252 formed of an insulating material.

The interconnector 300 is disposed to extend between the first and second solar cells C1 and C2 in the first direction x. The first conductive lines 210 connected to the first solar cell C1 and the second conductive lines 220 connected to the second solar cell C2 are commonly connected to the interconnector 300. Hence, the plurality of solar cells C1 and C2 are connected in series to each other in the second direction y.

The embodiment of the invention is illustrated and described using the solar cell module including the interconnector 300.

Each component of the solar cell module is described in detail below.

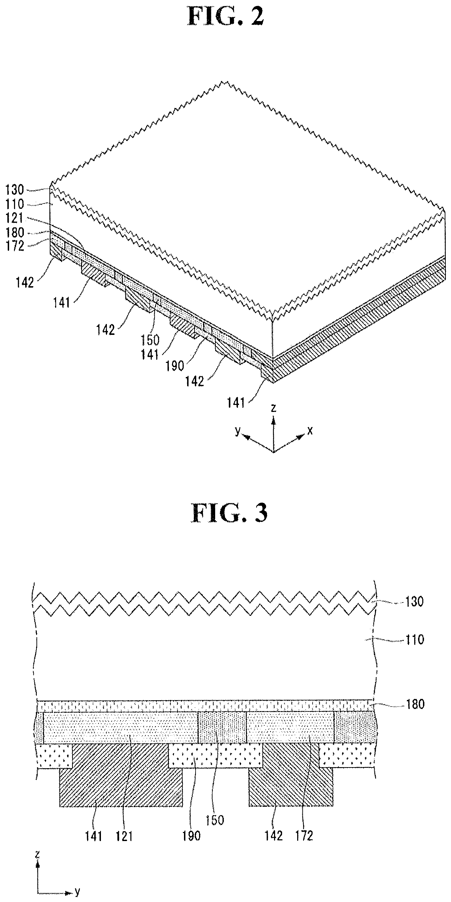

FIG. 2 is a partial perspective view illustrating an example of a solar cell applied to a solar cell module shown in FIG. 1. FIG. 3 is a cross-sectional view of a solar cell shown in FIG. 2 in a second direction.

As shown in FIGS. 2 and 3, an example of a solar cell according to the embodiment of the invention may include an anti-reflection layer 130, a semiconductor substrate 110, a tunnel layer 180, a plurality of emitter regions 121, a plurality of back surface field regions 172, a plurality of intrinsic semiconductor layers 150, a passivation layer 190, a plurality of first electrodes 141, and a plurality of second electrodes 142.

In the embodiment disclosed herein, the anti-reflection layer 130, the intrinsic semiconductor layer 150, the tunnel layer 180, and the passivation layer 190 may be omitted, if desired or necessary. However, when the solar cell includes them, efficiency of the solar cell may be further improved.

Thus, the embodiment of the invention is described using the solar cell including the anti-reflection layer 130, the intrinsic semiconductor layer 150, the tunnel layer 180, and the passivation layer 190 by way of example.

The semiconductor substrate 110 may be formed of at least one of single crystal silicon and polycrystalline silicon containing impurities of a first conductive type. For example, the semiconductor substrate 110 may be formed of a single crystal silicon wafer.

In the embodiment disclosed herein, the first conductive type may be one of an n-type and a p-type.

When the semiconductor substrate 110 is of the p-type, the semiconductor substrate 110 may be doped with impurities of a group III element, such as boron (B), gallium (Ga), and indium (In). Alternatively, when the semiconductor substrate 110 is of the n-type, the semiconductor substrate 110 may be doped with impurities of a group V element, such as phosphorus (P), arsenic (As), and antimony (Sb).

In the following description, the embodiment of the invention is described using an example where the first conductive type is the n-type.

A front surface of the semiconductor substrate 110 may be an uneven surface having a plurality of uneven portions or having uneven characteristics. Thus, the emitter regions 121 positioned on the front surface of the semiconductor substrate 110 may have an uneven surface.

Hence, an amount of light reflected from the front surface of the semiconductor substrate 110 may decrease, and an amount of light incident on the inside of the semiconductor substrate 110 may increase.

The anti-reflection layer 130 may be positioned on the front surface of the semiconductor substrate 110, so as to minimize a reflection of light incident on the front surface of the semiconductor substrate 110 from the outside. The anti-reflection layer 130 may be formed of at least one of aluminum oxide (AlOx), silicon nitride (SiNx), silicon oxide (SiOx), and silicon oxynitride (SiOxNy).

The tunnel layer 180 is disposed on an entire back surface of the semiconductor substrate 110 while directly contacting the entire back surface of the semiconductor substrate 110 and may include a dielectric material. Thus, as shown in FIGS. 2 and 3, the tunnel layer 180 may pass through carriers produced in the semiconductor substrate 110.

In other words, the tunnel layer 180 may pass through carriers produced in the semiconductor substrate 110 and may perform a passivation function with respect to the back surface of the semiconductor substrate 110.

The tunnel layer 180 may be formed of a dielectric material including silicon carbide (SiCx) or silicon oxide (SiOx) having strong durability at a high temperature equal to or higher than 600 °C. Other materials may be used.

The plurality of emitter regions 121 may be disposed on the back surface of the semiconductor substrate 110, and more specifically may directly contact a portion of a back surface of the tunnel layer 180. The plurality of emitter regions 121 may extend in the first direction x.

The emitter regions 121 may be formed of polycrystalline silicon material of a second conductive type opposite the first conductive type. The emitter regions 121 may form a p-n junction together with the semiconductor substrate 110 with the tunnel layer 180 interposed therebetween.

Because each emitter region 121 forms the p-n junction together with the semiconductor substrate 110, the emitter region 121 may be of the p-type. However, if the semiconductor substrate 110 is of the p-type unlike the embodiment described above, the emitter region 121 may be of the n-type. In this instance, separated electrons may move to the plurality of emitter regions 121, and separated holes may move to the plurality of back surface field regions 172.

Returning to the embodiment of the invention, when the emitter region 121 is of the p-type, the emitter region 121 may be doped with impurities of a group III element such as B, Ga, and In. On the contrary, if the emitter region 121 is of the n-type, the emitter region 121 may be doped with impurities of a group V element such as P, As, and Sb.

The plurality of back surface field regions 172 may be disposed on the back surface of the semiconductor substrate 110. More specifically, the plurality of back surface field regions 172 may directly contact a portion (spaced apart from each of the plurality of emitter regions 121) of the back surface of the tunnel layer 180. The plurality of back surface field regions 172 may extend in the first direction x parallel to the plurality of emitter regions 121.

The back surface field regions 172 may be formed of polycrystalline silicon material more heavily doped than the semiconductor substrate 110 with impurities of the first conductive type. Thus, when the semiconductor substrate 110 is doped with, for example, n-type impurities, each of the plurality of back surface field regions 172 may be an n⁺-type region.

A potential barrier is formed by a difference between impurity concentrations of the semiconductor substrate 110 and the back surface field regions 172. Hence, the back surface field regions 172 can prevent or reduce holes from moving to the back surface field regions 172 used as a moving path of electrons through the potential barrier and can make it easier for carriers (for example, electrons) to move to the back surface field regions 172.

Thus, the embodiment of the invention can reduce an amount of carriers lost by a recombination and/or a disappearance of electrons and holes at and around the back surface field regions 172 or at and around the first and second electrodes 141 and 142 and can accelerate a movement of electrons, thereby increasing an amount of electrons moving to the back surface field regions 172.

FIGS. 2 and 3 illustrate that the emitter regions 121 and the back surface field regions 172 are formed on the back surface of the tunnel layer 180 using polycrystalline silicon material, by way of example. Unlike FIGS. 2 and 3, if the tunnel layer 180 is omitted, the emitter regions 121 and the back surface field regions 172 may be doped by diffusing impurities into the back surface of the semiconductor substrate 110.

In this instance, the emitter regions 121 and the back surface field regions 172 may be formed of the same material (for example, single crystal silicon) as the semiconductor substrate 110.

The intrinsic semiconductor layer 150 may be formed on the back surface of the tunnel layer 180 exposed between the emitter region 121 and the back surface field region 172. The intrinsic semiconductor layer 150 may be formed as an intrinsic polycrystalline silicon layer, that is not doped with impurities of the first conductive type or impurities of the second conductive type, unlike the emitter region 121 and the back surface field region 172.

Further, as shown in FIGS. 2 and 3, the intrinsic semiconductor layer 150 may be configured such that both sides directly contact the side of the emitter region 121 and the side of the back surface field region 172, respectively.

The passivation layer 190 removes a defect resulting from a dangling bond formed in a back surface of a polycrystalline silicon layer formed at the back surface field regions 172, the intrinsic semiconductor layers 150, and the emitter regions 121, and thus can prevent carriers produced in the semiconductor substrate 110 from being recombined and disappeared by the dangling bond.

The first electrode 141 may be connected to the emitter region 121 and may extend in the first direction x. The first electrode 141 may collect carriers (for example, holes) moving to the emitter region 121.

The second electrode 142 may be connected to the back surface field region 172 and may extend in the first direction x in parallel with the first electrode 141. The second electrode 142 may collect carriers (for example, electrons) moving to the back surface field region 172.

As shown in FIG. 1, the first and second electrodes 141 and 142 extend in the first direction x and may be alternately disposed in the second direction y.

In the solar cell having the above-described structure according to the embodiment of the invention, holes collected by the first electrodes 141 and electrons collected by the second electrodes 142 may be used as electric power of an external device through an external circuit device.

The solar cell applied to the solar cell module according to the embodiment of the invention is not limited to FIGS. 2 and 3. The components of the solar cell may be variously changed, except that the first and second electrodes 141 and 142 included in the solar cell are formed on the back surface of the semiconductor substrate 110.

For example, the solar cell module according to the embodiment of the invention may use a metal wrap through (MWT) solar cell, that is configured such that a portion of the first electrode 141 and the emitter region 121 are positioned on the front surface of the semiconductor substrate 110, and the portion of the first electrode 141 is connected to a remaining portion of the first electrode 141 formed on the back surface of the semiconductor substrate 110 through a hole of the semiconductor substrate 110.

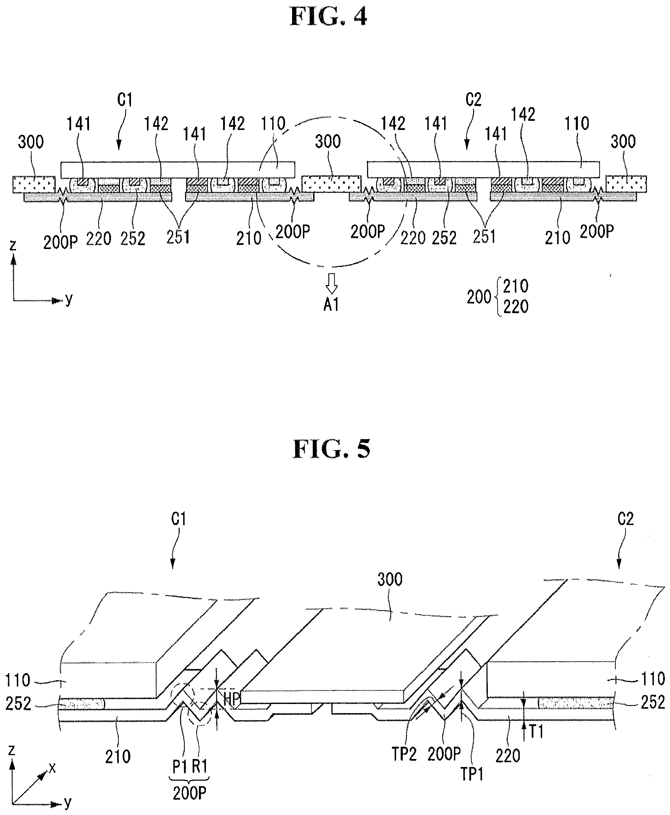

FIG. 4 illustrates a cross-sectional structure, in which the plurality of solar cells each having above-described configuration are connected in series using the conductive lines 200 and the interconnector 300 as shown in FIG. 1.

More specifically, FIG. 4 is a cross-sectional view taken along line X1-X1 of FIG. 1.

As shown in FIG. 4, a plurality of solar cells including a first solar cell C1 and a second solar cell C2 are arranged in the second direction y.

A longitudinal direction of a plurality of first and second electrodes 141 and 142 included in the first and second solar cells C1 and C2 corresponds to the first direction x.

The first and second solar cells C1 and C2, that are arranged in the second direction y as described above, are connected in series to each other in the second direction y using first and second conductive lines 200 and an interconnector 300 to form a string.

The first and second conductive lines 200 and the interconnector 300 may be formed of a conductive metal material. The first and second conductive lines 200 are connected to a back surface of a semiconductor substrate 110 of each solar cell and then connected to the interconnector 300 for a serial connection of the solar cells.

Each of the first and second conductive lines 200 may have a conductive wire shape having a circular cross section or a ribbon shape, in which a width is greater than a thickness.

More specifically, a plurality of first conductive lines 210 may overlap the plurality of first electrodes 141 included in each of the first and second solar cells C1 and C2 and may be connected to the plurality of first electrodes 141 through a conductive adhesive 251. Further, the plurality of first conductive lines 210 are insulated from the plurality of second electrodes 142 included in each of the first and second solar cells C1 and C2 through an insulating layer 252 formed of an insulating material.

In this instance, as shown in FIGS. 1 and 4, each of the plurality of first conductive lines 210 may protrude to the outside of the semiconductor substrate 110 toward the interconnector 300 disposed between the first and second solar cells C1 and C2.

A plurality of second conductive lines 220 may overlap the plurality of second electrodes 142 included in each of the first and second solar cells C1 and C2 and may be connected to the plurality of second electrodes 142 through a conductive adhesive 251. Further, the plurality of second conductive lines 220 may be insulated from the plurality of first electrodes 141 included in each of the first and second solar cells C1 and C2 through an insulating layer 252 formed of an insulating material.

In this instance, as shown in FIGS. 1 and 4, each of the plurality of second conductive lines 220 may protrude to the outside of the semiconductor substrate 110 toward the interconnector 300 disposed between the first and second solar cells C1 and C2.

The conductive adhesive 251 may be formed of a metal material including tin (Sn) or Sn-containing alloy. The conductive adhesive 251 may be formed as one of a solder paste including Sn or Sn-containing alloy, an epoxy solder paste, in which Sn or Sn-containing alloy is included in an epoxy, and a conductive paste.

The insulating layer 252 may be made of any material as long as an insulating material is used. For example, the insulating layer 252 may use one insulating material of an epoxy-based resin, polyimide, polyethylene, an acrylic-based resin, and a silicon-based resin.

As shown in FIGS. 1 and 4, a portion protruding to the outside of the semiconductor substrate 110 in each of the first and second conductive lines 210 and 220 connected to the back surface of each solar cell may be commonly connected to a back surface of the interconnector 300 between the first and second solar cells C1 and C2. Hence, the plurality of solar cells C1 and C2 may be connected in series to each other in the second direction y to form a string.

In the solar cell module having the above-described structure, when a bad connection between the first and second conductive lines 210 and 220 and the first and second electrodes 141 and 142 is generated among the plurality of solar cells, the first and second conductive lines 210 and 220 of a solar cell having the bad connection may be disconnected from the interconnector 300. Hence, only the bad solar cell can be easily replaced.

As shown in FIG. 4, in the solar cell module according to the embodiment of the invention, a remaining portion except a portion of each conductive line 200 connected to the first electrode 141 or the second electrode 142 includes an uneven portion 200P.

A cross section of the uneven portion 200P has a zigzag shape formed by folding the conductive line 200 in a thickness direction z of the semiconductor substrate 110. The uneven portion 200P has folds.

More specifically, the remaining portion of the conductive line 200 having the uneven portion 200P is positioned between the semiconductor substrates 110 of the first and second solar cells C1 and C2 when viewed from the plane of the solar cell module.

For example, as shown in FIG. 4, a portion of the first conductive line 210 exposed between the semiconductor substrate 110 of the first solar cell C1 and the interconnector 300 has an uneven portion 200P when viewed from the front surface of the solar cell module Further, a portion of the second conductive line 220 exposed between the semiconductor substrate 110 of the second solar cell C2 and the interconnector 300 has an uneven portion 200P when viewed from the front surface of the solar cell module.

In the solar cell module according to the embodiment of the invention, when the plurality of solar cells are connected in series using the conductive lines 200 including the zigzag-shaped uneven portion 200P, the conductive line 200 has flexibility in the second direction y due to the uneven portion 200P even if the conductive line 200 is thermally expanded. Hence, when the conductive line 200 is attached to the back surface of the semiconductor substrate 110 or is subsequently used in the solar cell module, a thermal stress of the conductive line 200 can be reduced even if heat is applied to the conductive line 200 due to an inner temperature increase of the solar cell module.

Further, the uneven portion 200P can prevent the conductive line 200 from being detached from the interconnector 300 and prevent the interconnector 300 from bending by the thermal expansion of the conductive line 200.

Furthermore, light incident between the semiconductor substrate 110 and the interconnector 300 may be again reflected by an inclined surface of the uneven portion 200P.

The re-reflected light may be again reflected by a front transparent substrate disposed on a front surface of a solar cell and may be incident on another solar cell adjacent to the solar cell. Hence, an optical gain of the solar cell module can be further improved, and efficiency of the solar cell module can be further improved.

A structure of the uneven portion 200P of the conductive line 200 is described in detail with reference to FIG. 5.

FIG. 5 is a partial perspective view enlarging a portion A1 of FIG. 4 so as to explain in detail the uneven portion 200P of the conductive line 200.

As shown in FIG. 5, in the solar cell module according to the embodiment of the invention, a portion of each conductive line 200 exposed between the semiconductor substrate 110 of each solar cell and the interconnector 300 has an uneven portion 200P when viewed from the front surface of the solar cell module.

FIG. 5 illustrates that the uneven portion 200P of the conductive line 200 is formed between the semiconductor substrate 110 and the interconnector 300 except an overlap portion between the conductive line 200 and the semiconductor substrate 110 or the interconnector 300, as an example. However, the embodiment of the invention is not limited thereto. For example, an end of the uneven portion 200P may overlap the semiconductor substrate 110 or the interconnector 300. As shown in FIG. 5, the uneven portion 200P includes a peak P1 and a valley R1.

The peak P1 and the valley R1 of the uneven portion 200P may extend in a longitudinal direction (i.e., the first direction x) of the interconnector 300.

Hence, even if the conductive line 200 is thermally expanded in the second direction y by heat generated during a process for manufacturing the solar cell module or during the use of the solar cell module, a stress of the conductive line 200 can be reduced by the uneven portion 200P. Further, the uneven portion 200P can prevent the conductive line 200 from being detached from the interconnector 300 and prevent the interconnector 300 from bending by the thermal expansion of the conductive line 200.

Furthermore, the optical gain of the solar cell module can be further improved by the inclined surface on the surface of the uneven portion 200P, and thus the efficiency of the solar cell module can be further improved.

Thicknesses TP1 and TP2 of the uneven portion 200P of the conductive line 200 may be substantially equal to a thickness T1 of a portion of the conductive line 200, at which the uneven portion 200P is not formed, within a margin of error of 10 %.

For example, as shown in FIG. 5, the thicknesses TP1 and TP2 of the uneven portion 200P of the conductive lines 210 and 220 between the semiconductor substrate 110 and the interconnector 300 may be substantially equal to the thickness T1 of each of the conductive lines 210 and 220 overlapping the semiconductor substrate 110 within a margin of error of 10 %.

For example, when the thickness T1 of the conductive line 200 overlapping the semiconductor substrate 110 is 0.05 mm to 0.3 mm, the thicknesses TP1 and TP2 of the uneven portion 200P may be 0.05 mm to 0.3 mm and may be substantially equal to the thickness T1 of the conductive line 200 within a margin of error of 10 %.

Further, the thicknesses TP1 and TP2 of the uneven portion 200P may be uniform within a margin of error of 10 %.

For example, as shown in FIG. 5, the thickness TP1 of the uneven portion 200P at the peak P1 may be substantially equal to the thickness TP2 of the uneven portion 200P at an inclined surface between the peak P1 and the valley R1 within a margin of error of 10 %.

A height HP of the uneven portion 200P measured from the valley R1 to the peak P1 of the uneven portion 200P may be greater than the thicknesses TP1 and TP2 of the uneven portion 200P.

Alternatively, the height HP of the uneven portion 200P measured from the valley R1 to the peak P1 of the uneven portion 200P may be set in consideration of a thickness of the interconnector 300 and a thickness of an encapsulant (for example, ethylene vinyl acetate (EVA)), that is positioned on the front surfaces and the back surfaces of the solar cells to protect the solar cells from an external impact.

For example, when a front encapsulant and a back encapsulant each have a thickness of about 0.5 mm and the interconnector 300 has a thickness of about 0.2 mm, the height HP of the uneven portion 200P from the valley R1 to the peak P1 may be 0.03 mm to 1 mm.

When the height HP of the uneven portion 200P is equal to or greater than 0.03 mm, minimum flexibility of the uneven portion 200P may be secured. On the other hand, when the height HP of the uneven portion 200P excessively increases in a state where the flexibility of the uneven portion 200P is sufficiently secured, the uneven portion 200P may excessively protrude toward the front surface or the back surface of the solar cell module. Hence, the encapsulant (for example, EVA) may be damaged. Considering this, the height HP of the uneven portion 200P may be equal to or less than 1 mm.

However, the height HP of the uneven portion 200P of the conductive line 200 is not limited to the above-described range. The height HP of the uneven portion 200P may be changed depending on changes in the thickness of the front encapsulant, the thickness of the back encapsulant, and the thickness of the interconnector 300.

So far, the present disclosure described the solar cell module according to the first embodiment of the invention, that is configured such that the interconnector 300 is separately disposed between the plurality of solar cells and the plurality of solar cells are connected in series to each other through the conductive lines 200 and the interconnector 300, by way of example.

However, the present disclosure may be applied to a solar cell module, that is configured such that the interconnector 300 is omitted and the plurality of solar cells are connected in series to each other using only the conductive lines 200. This is described in detail below.

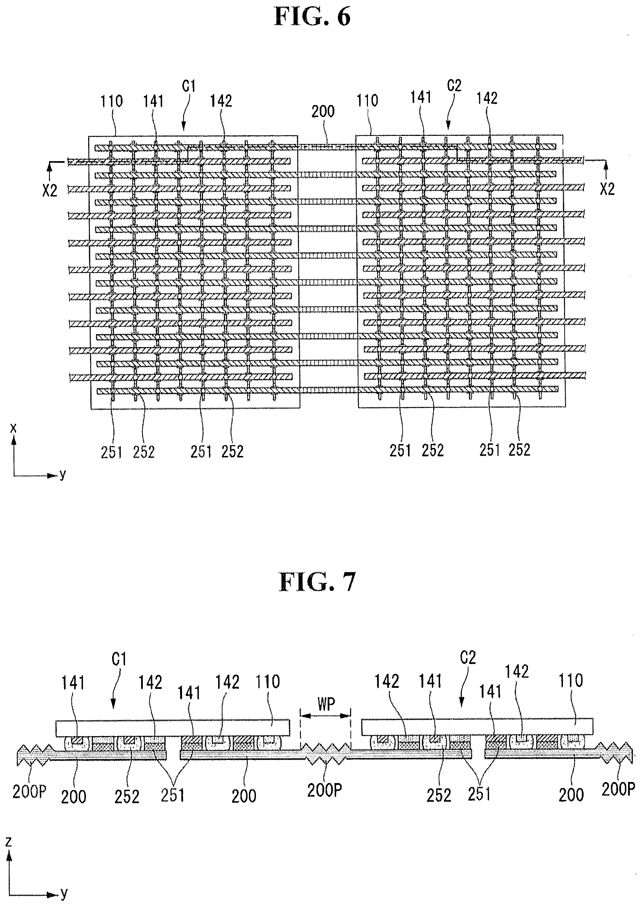

FIGS. 6 and 7 illustrate a solar cell module according to an example forming background art of the invention, not covered by the claims.

More specifically, FIG. 6 illustrates an example of a shape of a solar cell module according to the example when viewed from a back surface of the solar cell module. FIG. 7 is a cross-sectional view taken along line X2-X2 of FIG. 6.

The description duplicative with that illustrated in FIGS. 1 to 5 is omitted in FIGS. 6 and 7, and only a difference between FIGS. 1 to 5 and FIGS. 6 and 7 is mainly described.

As shown in FIGS. 6 and 7, a separate interconnector may be omitted in a solar cell module according to the second embodiment of the invention.

In the second embodiment of the invention, each of a plurality of conductive lines 200 for connecting first and second solar cells C1 and C2 in series may be connected to both a back surface of a semiconductor substrate 110 of the first solar cell C1 and a back surface of a semiconductor substrate 110 of the second solar cell C2.

Namely, each conductive line 200 according to the second embodiment of the invention may be relatively long in a second direction y enough to overlap the semiconductor substrates 110 of the first and second solar cells C1 and C2 arranged adjacent to each other in the second direction y, unlike the first and second conductive lines 200 described in the first embodiment.

As shown in FIGS. 6 and 7, a portion of the conductive line 200 overlapping the first solar cell C1 may be connected to first electrodes 141 of the first solar cell C1 through a conductive adhesive 251 and may be insulated from second electrodes 142 of the first solar cell C1 through an insulating layer 252. Further, a portion of the conductive line 200 overlapping the second solar cell C2 may be connected to second electrodes 142 of the second solar cell C2 through the conductive adhesive 251 and may be insulated from first electrodes 141 of the second solar cell C2 through the insulating layer 252.

In the solar cell module according to the second embodiment of the invention, the conductive line 200 connected to the first solar cell C1 and the conductive line 200 connected to the second solar cell C2 may be formed as one body, for example, a conductor by a metal ribbon. Unlike the first embodiment of the invention, the interconnector 300 is omitted, and the adjacent solar cells may be connected in series to each other using only the conductive lines 200.

As shown in FIG. 7, each conductive line 200 according to the second embodiment of the invention may include an uneven portion 200P between the semiconductor substrate 110 of the first solar cell C1 and the semiconductor substrate 110 of the second solar cell C2, in the same manner as the first embodiment.

A height of the uneven portion 200P included in the conductive line 200 according to the second embodiment of the invention may be 0.03 mm to 1 mm, in the same manner as the first embodiment.

A width WP in the second direction y of the uneven portion 200P of the conductive line 200 between two adjacent solar cells may be less than a distance of the second direction y between the semiconductor substrates 110 of the two adjacent solar cells. For example, the width WP may be 2 mm to 6 mm.

Further, a length of the conductive line 200 between the semiconductor substrates 110 of the first and second solar cells C1 and C2 may be greater than a distance between the semiconductor substrates 110 of the first and second solar cells C1 and C2 due to the uneven portion 200P of the conductive line 200.

So far, embodiments of the invention described the solar cell module, that is configured such that at all of the first and second electrodes 141 and 142 are disposed on the back surface of the solar cell, by way of example. However, embodiments of the invention may be applied to a conventional solar cell, in which first electrodes are disposed on a front surface of the solar cell and second electrodes are disposed on a back surface of the solar cell. This is described in detail below.

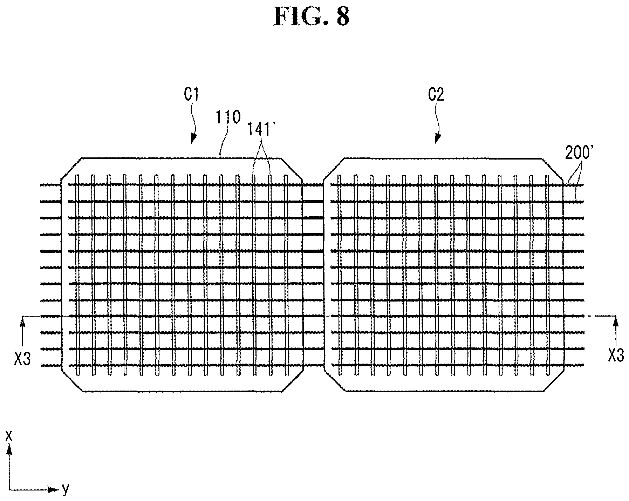

FIGS. 8 to 11 illustrate a solar cell module according to a further example of the invention, not covered by the claims. More specifically, FIG. 8 illustrates an example of a shape of a solar cell module according to the further example when viewed from a front surface of the solar cell module.

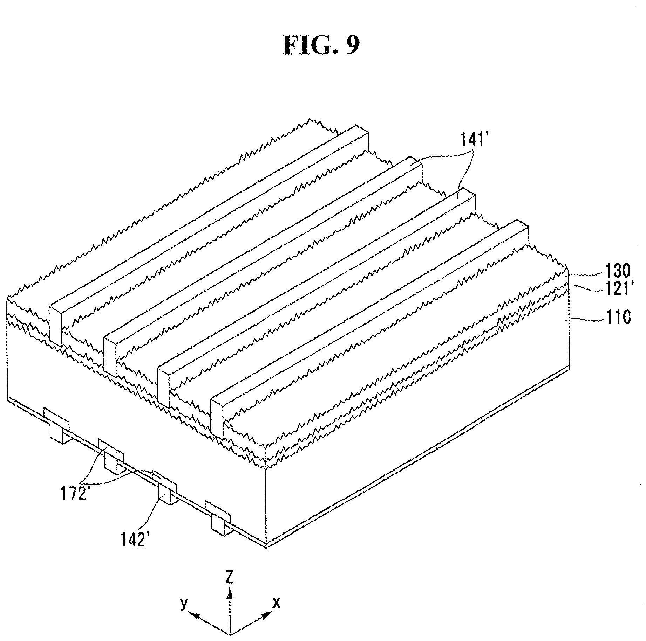

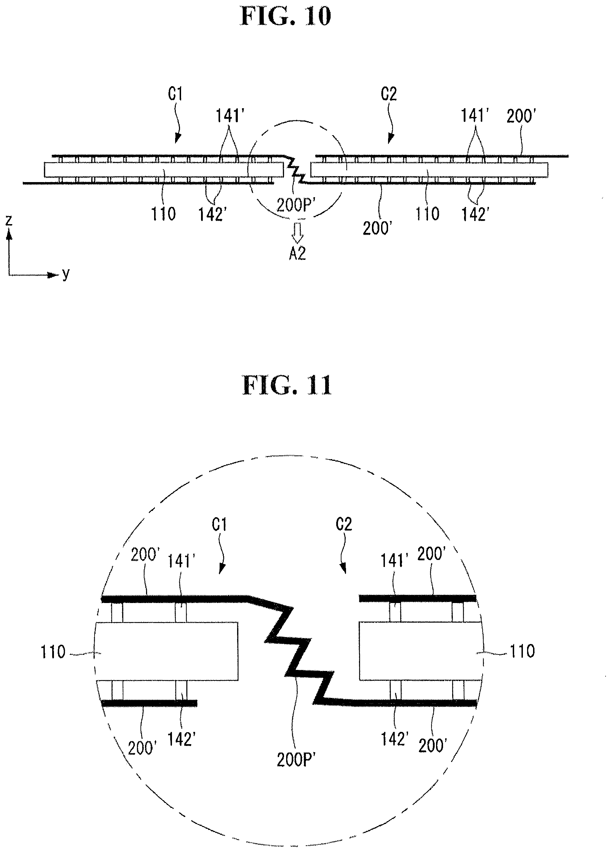

FIG. 9 is a partial perspective view illustrating an example of a conventional solar cell applied to a solar cell module according to the third embodiment of the invention. FIG. 10 is a cross-sectional view taken along line X3-X3 of FIG. 8. FIG. 11 is a cross-sectional view enlarging a portion A2 of FIG. 10.

The description duplicative with that illustrated in FIGS. 1 to 7 is omitted in FIGS. 8 to 11, and only a difference between FIGS. 1 to 7 and FIGS. 8 to 11 is mainly described.

As shown in FIG. 8, in a solar cell module according to the third embodiment of the invention, each of first and second solar cells C1 and C2 may include first electrodes 141' on a front surface of a semiconductor substrate 110 and second electrodes 142' on a back surface of the semiconductor substrate 110.

As shown in FIGS. 8 and 10, each of a plurality of conductive lines 200' may extend in a second direction y. Each conductive line 200' may be connected to a front surface of the first solar cell C1 through a conductive adhesive and may be connected to a back surface of the second solar cell C2 through the conductive adhesive, thereby connecting the first and second solar cells C1 and C2 in series.

An example of a solar cell applied to the third embodiment of the invention is described in detail below.

As shown in FIG. 9, a solar cell applied to the third embodiment of the invention may include an emitter region 121' that is doped with impurities of a second conductive type at a front surface of a semiconductor substrate 110 containing impurities of a first conductive type, and a back surface field region 172' that is more heavily doped than the semiconductor substrate 110 with impurities of the first conductive type at a back surface of the semiconductor substrate 110.

As shown in FIG. 9, the emitter region 121' may be entirely formed at the front surface of the semiconductor substrate 110, and the back surface field region 172' may be selectively formed only at a formation portion of the second electrodes 142' in the back surface of the semiconductor substrate 110.

However, the embodiment of the invention is not limited thereto. For example, the emitter region 121' may be selectively formed only at a formation portion of the first electrodes 141' in the front surface of the semiconductor substrate 110; or may be relatively heavily doped only at a formation portion of the first electrodes 141' while being entirely formed at the front surface of the semiconductor substrate 110.

Further, the back surface field region 172' may be entirely formed at the back surface of the semiconductor substrate 110, unlike FIG. 9.

As shown in FIG. 9, the first electrode 141' may be positioned on the front surface of the semiconductor substrate 110 and connected to the emitter region 121'. The second electrode 142' may be positioned on the back surface of the semiconductor substrate 110 and connected to the back surface field region 172'.

The plurality of first electrodes 141' may extend in the first direction x, and the plurality of second electrodes 142' may extend in the first direction x.

An example of a pattern of the first and second electrodes 141' and 142' is shown in FIG. 9. Thus, the pattern of the first and second electrodes 141' and 142' may be variously changed.

As shown in FIG. 10, the conductive line 200' may be connected to the front surface and the back surface of the solar cells through a conductive adhesive, thereby connecting the plurality of solar cells in series.

More specifically, as shown in FIG. 10, each conductive line 200' extending in the second direction y may be connected to the first electrode 141' on the front surface of the semiconductor substrate 110 of the first solar cell C1 through the conductive adhesive and may be connected to the second electrode 142' on the back surface of the semiconductor substrate 110 of the second solar cell C2 through the conductive adhesive.

Each conductive line 200' may be formed by integrating a portion connected to the first solar cell C1 and a portion connected to the second solar cell C2. Each conductive line 200' may have a wire-shaped cross section, in which a width and a thickness are equal to each other. The number of conductive lines 200' may be 6 to 33.

As shown in FIG. 11, each conductive line 200' of the solar cell module according to the third embodiment of the invention may include an uneven portion 200P between the first and second solar cells C1 and C2.

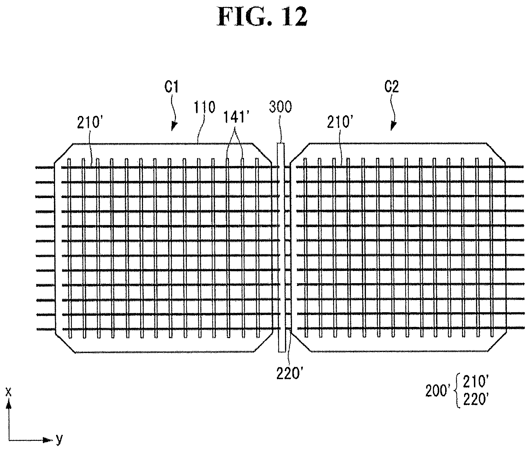

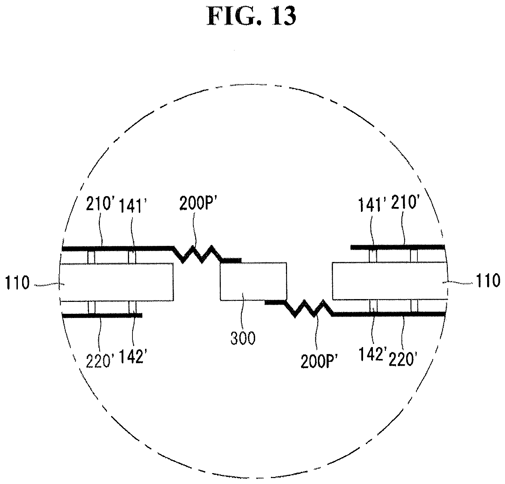

The third embodiment of the invention described that the plurality of conductive lines 200' connect the adjacent solar cells in series in the solar cell module, to which the conventional solar cell is applied, by way of example. However, an interconnector may be used in the solar cell module, to which the conventional solar cell is applied, as in the first embodiment of the invention. This is described in detail below with reference to FIGS. 12 and 13.

FIGS. 12 and 13 illustrate a solar cell module according to a still further example forming background art of the invention, not covered by the claims.

More specifically, FIG. 12 illustrates an example of a shape of a solar cell module according to the still further example when viewed from a front surface of the solar cell module. FIG. 13 is a cross-sectional view enlarging a connection portion of an interconnector according to the still further example.

As shown in FIGS. 12 and 13, a solar cell module according to the still further example may include an interconnector 300 in the same manner as the first embodiment of the invention.

First conductive lines 210' connected to first electrodes 141' on a front surface of a first solar cell C1 may be connected to a front surface of the interconnector 300. Second conductive lines 220' connected to second electrodes 142' on a back surface of a second solar cell C2 may be connected to a back surface of the interconnector 300.

As shown in FIG. 13, in the solar cell module according to the still further example, each conductive line 200 may include an uneven portion 200P between the first solar cell C1 and the interconnector 300 or between the second solar cell C2 and the interconnector 300.

Although embodiments have been described with reference to a number of illustrative embodiments thereof, it should be understood that numerous other modifications and embodiments can be devised by those skilled in the art without departing from the scope of the appended claims. More particularly, various variations and modifications are possible in the component parts and/or arrangements of the subject combination arrangement without departing from the scope of the appended claims.

## Claims

1. A solar cell module comprising:
first and second solar cells (C1, C2) each including a semiconductor substrate (110) and first electrodes (141) and second electrodes (142) on a back surface of the semiconductor substrate (110), the first (141) and second (142) electrodes having different polarities and extending in a first direction, the first and second solar cells (C1, C2) being arranged adjacent to each other in a second direction crossing the first direction; and
a plurality of first conductive lines (210) extending in the second direction, disposed on the back surface of the semiconductor substrate (110) of each of the the first and second solar cells (C1, C2), and connected to the first electrodes (141) of each of the first and second solar cells (C1, C2) through a conductive adhesive (251) and insulated from the second electrodes (142) of each of the first and second solar cells (C1, C2) through an insulating layer (252);
a plurality of second conductive lines (220) extending in the second direction, disposed on the back surface of the semiconductor substrate (110) of the first and second solar cells (C1, C2) spaced apart from the first conductive lines (210), and connected to the second electrodes (142) of each of the first and second solar cells (C1, C2) through the conductive adhesive (251), and insulated from the first electrodes (141) of each of the first and second solar cells (C1, C2) through the insulating layer (252);
an interconnector (300) extending in the first direction between the first and second solar cells (C1, C2), and commonly connected to the first conductive lines (210) connected to the first solar cell and to the second conductive lines (220) connected to the second solar cell, **characterized in that**:
each of the plurality of first conductive lines (210) and the plurality of second conductive lines (220) includes an uneven portion (200P) located in a remaining portion except a portion of the respective first or second conductive line (210, 220) that is connected to the first electrode (141) or second electrode (142),
wherein the uneven portion of each of the first conductive lines (210) is positioned between the interconnector (300) and the semiconductor substrate (110) of the first solar cell (C1) when viewed from a front of the solar cell module and the uneven portion of each of the second conductive lines (220) is positioned between the interconnector (300) and the semiconductor substrate (110) of the second solar cell (C2) when viewed from a front of the solar cell module,
wherein each uneven portion (200P) of the first and second conductive lines (210, 220) has a peak and a valley, each of which extends in the first direction,
wherein each uneven portion (200P) has a cross section having a zigzag shape formed by folding the respective first or second conductive line (210, 220) in a thickness direction of the semiconductor substrate (110), and wherein each of the first and second conductive lines (210, 220) has a flexibility in the second direction by the uneven portion (200P).

2. The solar cell module of claim 1, wherein a thickness of the uneven portion (200P) of each of the first and second conductive lines (210, 220) is substantially equal to a thickness of a portion of each of the first and second conductive lines (210, 220) not including the uneven portion (200P) within a margin of error of 10 %.

3. The solar cell module of claim 1 or 2, wherein a thickness of the uneven portion (200P) of each of the first and second conductive lines (210, 220) is uniform within a margin of error of 10 % over the entire uneven portion, and
wherein a height of the uneven portion (200P) of each of the first and second conductive lines (210, 220) is greater than a thickness of the uneven portion.

4. The solar cell module of any one preceding claim,
wherein a height (HP) of the uneven portion (200P) of each of the first and second conductive lines (210, 220) measured from the valley to the peak is 0.03 mm to 1 mm.

5. The solar cell module of any of the preceding claim, wherein the semiconductor substrate (110) of each of the first and second solar cells (C1, C2) is doped with impurities of a first conductive type,
wherein the first electrodes (141) of each of the first and second solar cells are connected to an emitter region (121) that is positioned at the back surface of the semiconductor substrate and is doped with impurities of a second conductive type opposite the first conductive type, and
wherein the second electrodes (142) of each of the first and second solar cells are connected to a back surface field region (172) that is positioned at the back surface of the semiconductor substrate and is more heavily doped than the semiconductor substrate with impurities of the first conductive type.

## Patentansprüche

1. Solarzellenmodul, umfassend:
eine erste und eine zweite Solarzelle (C1, C2), die jeweils ein Halbleitersubstrat (110) und erste Elektroden (141) und zweite Elektroden (142) an einer hinteren Oberfläche des Halbleitersubstrats (110) aufweisen, wobei die ersten (141) und die zweiten (142) Elektroden unterschiedliche Polaritäten aufweisen und sich in einer ersten Richtung erstrecken, wobei die erste und die zweite Solarzelle (C1, C2) in einer zweiten Richtung, die die erste Richtung kreuzt, angrenzend zueinander angeordnet sind; und
eine Vielzahl von ersten leitfähigen Leitungen (210), die sich in der zweiten Richtung erstreckt, die an der hinteren Oberfläche des Halbleitersubstrats (110) jeder der der ersten und der zweiten Solarzelle (C1, C2) eingerichtet und mit den ersten Elektroden (141) jeder der ersten und der zweiten Solarzelle (C1, C2) durch einen leitfähigen Klebstoff (251) verbunden und durch eine Isolierschicht (252) von den zweiten Elektroden (142) jeder der ersten und der zweiten Solarzelle (C1, C2) isoliert ist;
eine Vielzahl von zweiten leitfähigen Leitungen (220), die sich in der zweiten Richtung erstreckt, die an der hinteren Oberfläche des Halbleitersubstrats (110) der ersten und der zweiten Solarzelle (C1, C2) eingerichtet, die von den ersten leitfähigen Leitungen (210) beabstandet und mit den zweiten Elektroden (142) jeder der ersten und der zweiten Solarzelle (C1, C2) durch den leitfähigen Klebstoff (251) verbunden und von den ersten Elektroden (141) jeder der ersten und der zweiten Solarzelle (C1, C2) durch die Isolierschicht (252) isoliert ist;
einen Zwischenverbinder (300), der sich in der ersten Richtung zwischen der ersten und der zweiten Solarzelle (C1, C2) erstreckt und gewöhnlich mit den ersten leitfähigen Leitungen (210), die mit der ersten Solarzelle verbunden sind, und mit den zweiten leitfähigen Leitungen (220), die mit der zweiten Solarzelle verbunden sind, verbunden ist, **dadurch gekennzeichnet, dass**:
jede der Vielzahl von ersten leitfähigen Leitungen (210) und der Vielzahl von zweiten leitfähigen Leitungen (220) einen unebenen Abschnitt (200P) einschließt, der sich in einem verbleibenden Abschnitt, außer einem Abschnitt der jeweiligen ersten oder zweiten leitfähigen Leitungen (210, 220), der mit den ersten Elektroden (141) oder den zweiten Elektroden (142) verbunden ist, befindet,
wobei der unebene Abschnitt jeder der ersten leitfähigen Leitungen (210) zwischen dem Zwischenverbinder (300) und dem Halbleitersubstrat (110) der ersten Solarzelle (C1) positioniert ist, wenn er von einer Vorderseite des Solarzellenmoduls aus betrachtet wird, und der unebene Abschnitt jeder der zweiten leitfähigen Leitungen (220) zwischen dem Zwischenverbinder (300) und dem Halbleitersubstrat (110) der zweiten Solarzelle (C2) positioniert ist, wenn er von einer Vorderseite des Solarzellenmoduls aus betrachtet wird,
wobei jeder unebene Abschnitt (200P) der ersten und der zweiten leitfähigen Leitungen (210, 220) eine Spitze und ein Tal aufweist, wobei sich jedes dieser in der ersten Richtung erstreckt,
wobei jeder unebene Abschnitt (200P) einen Querschnitt, der eine Zickzackform, die mittels eines Faltens der jeweiligen ersten oder zweiten leitfähigen Leitungen (210, 220) in einer Dickenrichtung des Halbleitersubstrats (110) ausgebildet wird, aufweist und wobei jede der ersten und der zweiten leitfähigen Leitungen (210, 220) eine Flexibilität in der zweiten Richtung mittels des unebenen Abschnitts (200P) aufweist.

2. Solarzellenmodul nach Anspruch 1, wobei eine Dicke des unebenen Abschnitts (200P) jeder der ersten und der zweiten leitfähigen Leitungen (210, 220) im Wesentlichen gleich einer Dicke eines Abschnitts jeder der ersten und der zweiten leitfähigen Leitungen (210, 220), den unebenen Abschnitt (200P) innerhalb einer Fehlergrenze von 10 % nicht eingeschlossen, ist.

3. Solarzellenmodul nach Anspruch 1 oder 2, wobei eine Dicke des unebenen Abschnitts (200P) jeder der ersten und der zweiten leitfähigen Leitungen (210, 220) innerhalb einer Fehlergrenze von 10 % über den gesamten unebenen Abschnitt hinweg gleichmäßig ist und
wobei eine Höhe des unebenen Abschnitts (200P) jeder der ersten und der zweiten leitfähigen Leitungen (210, 220) größer als eine Dicke des unebenen Abschnitts ist.

4. Solarzellenmodul nach einem der vorstehenden Ansprüche,
wobei eine Höhe (HP) des unebenen Abschnitts (200P) jeder der ersten und der zweiten leitfähigen Leitungen (210, 220), von dem Tal zu der Spitze gemessen, 0,03 mm bis 1 mm beträgt.

5. Solarzellenmodul nach einem der vorstehenden Ansprüche, wobei das Halbleitersubstrat (110) jeder der ersten und der zweiten Solarzelle (C1, C2) mit Verunreinigungen einer ersten leitfähigen Art dotiert ist,
wobei die ersten Elektroden (141) jeder der ersten und der zweiten Solarzelle mit einem Emitterbereich (121), der an der hinteren Oberfläche des Halbleitersubstrats positioniert ist und mit Verunreinigungen einer zweiten leitfähigen Art gegenüber der ersten leitfähigen Art dotiert ist, verbunden sind und
wobei die zweiten Elektroden (142) jeder der ersten und der zweiten Solarzelle mit einem hinteren Oberflächenfeldbereich (172), der an der hinteren Oberfläche des Halbleitersubstrats positioniert ist und stärker als das Halbleitersubstrat mit Verunreinigungen der ersten leitfähigen Art dotiert ist, verbunden sind.

## Revendications

1. Module de cellules solaires comprenant:
des première et seconde cellules solaires (C1, C2), chacune comportant un substrat semi-conducteur (110) et des premières électrodes (141) et des secondes électrodes (142) sur une surface arrière du substrat semi-conducteur (110), les première (141) et seconde (142) électrodes ayant des polarités différentes et s'étendant dans une première direction, les première et seconde cellules solaires (C1, C2) étant disposées adjacentes l'une à l'autre dans une seconde direction croisant la première direction; et
une pluralité de premières lignes conductrices (210) s'étendant dans la seconde direction, disposées sur la surface arrière du substrat semi-conducteur (110) de chacune des première et seconde cellules solaires (C1, C2), et connectées aux premières électrodes (141) de chacune des première et seconde cellules solaires (C1, C2) à travers un adhésif conducteur (251) et isolées des secondes électrodes (142) de chacune des première et seconde cellules solaires (C1, C2) à travers une couche isolante (252);
une pluralité de secondes lignes conductrices (220) s'étendant dans la seconde direction, disposées sur la surface arrière du substrat semi-conducteur (110) des première et seconde cellules solaires (C1, C2) espacées des premières lignes conductrices (210), et connectées aux secondes électrodes (142) de chacune des première et seconde cellules solaires (C1, C2) à travers l'adhésif conducteur (251), et isolées des premières électrodes (141) de chacune des première et seconde cellules solaires (C1, C2) à travers la couche isolante (252) ;
un interconnecteur (300) s'étendant dans la première direction entre les première et seconde cellules solaires (C1, C2), et connecté couramment aux premières lignes conductrices (210) connectées à la première cellule solaire photovoltaïque et aux secondes lignes conductrices (220) connectées à la seconde cellule solaire, **caractérisé en ce que**:
chacune de la pluralité de premières lignes conductrices (210) et de la pluralité de secondes lignes conductrices (220) comporte une partie inégale (200P) située dans une partie restante à l'exception d'une partie de la première ou seconde ligne conductrice respective (210, 220) qui est connectée à la première électrode (141) ou à la seconde électrode (142),
la partie inégale de chacune des premières lignes conductrices (210) étant positionnée entre l'interconnecteur (300) et le substrat semi-conducteur (110) de la première cellule solaire photovoltaïque (C1) lorsqu'il est vu depuis l'avant du module de cellules solaires et la partie irrégulière de chacune des secondes lignes conductrices (220) étant positionnée entre l'interconnecteur (300) et le substrat semi-conducteur (110) de la seconde cellule solaire photovoltaïque (C2) lorsqu'il est vu depuis l'avant du module de cellules solaires,
chaque partie irrégulière (200P) des première et seconde lignes conductrices (210, 220) ayant un pic et une vallée, dont chacun s'étendant dans la première direction,
chaque partie irrégulière (200P) ayant une section transversale ayant une forme en zigzag formée en pliant la première ou la seconde ligne conductrice (210, 220) respective dans une direction d'épaisseur du substrat semi-conducteur (110), et chacune des première et seconde lignes conductrices (210, 220) ayant une flexibilité dans la seconde direction par la partie irrégulière (200P).

2. Module de cellules solaires selon la revendication 1, dans lequel une épaisseur de la partie inégale (200P) de chacune des première et seconde lignes conductrices (210, 220) est sensiblement égale à une épaisseur d'une partie de chacune des première et seconde lignes conductrices (210, 220) ne comportant pas la partie irrégulière (200P) dans une marge d'erreur de 10 %.

3. Module de cellules solaires selon la revendication 1 ou 2, dans lequel une épaisseur de la partie inégale (200P) de chacune des première et seconde lignes conductrices (210, 220) est uniforme dans une marge d'erreur de 10 % sur toute la partie irrégulière, et
une hauteur de la partie irrégulière (200P) de chacune des première et seconde lignes conductrices (210, 220) étant supérieure à une épaisseur de la partie irrégulière.

4. Module de cellules solaires selon l'une quelconque des revendications précédentes,
une hauteur (HP) de la partie irrégulière (200P) de chacune des première et seconde lignes conductrices (210, 220) mesurée à partir de la vallée au pic étant de 0,03 mm à 1 mm.

5. Module de cellules solaires selon l'une quelconque des revendications précédentes, dans lequel le substrat semi-conducteur (110) de chacune des première et seconde cellules solaires (C1, C2) est dopé avec des impuretés d'un premier type conducteur,
les premières électrodes (141) de chacune des première et seconde cellules solaires étant connectées à une région émettrice (121) qui est positionnée au niveau de la surface arrière du substrat semi-conducteur et est dopée avec des impuretés d'un second type conducteur opposé au premier type conducteur, et
les secondes électrodes (142) de chacune des première et seconde cellules solaires étant connectées à une région de champ de surface arrière (172) qui est positionnée au niveau de la surface arrière du substrat semi-conducteur et est plus fortement dopée que le substrat semi-conducteur avec des impuretés du premier type conducteur.
